(19) Europäisches Patentamt / European Patent Office / Office européen des brevets

(11) **EP 2 500 777 A1**

(12) **EUROPEAN PATENT APPLICATION**

(43) Date of publication:
**19.09.2012 Bulletin 2012/38**

(51) Int Cl.:
*G03F 7/40* *(2006.01)*  *G03F 7/20* *(2006.01)*

(21) Application number: **11158833.1**

(22) Date of filing: **18.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **BASF SE**
**67056 Ludwigshafen (DE)**

(72) Inventors:
• **Klipp, Andreas**
**67245, Lambsheim (DE)**

• **Oetter, Günter**
**67227 Frankenthal (DE)**
• **Montero Pancera, Sabrina**
**68519, Viernheim (DE)**
• **Bittner, Christian**
**64625 Bensheim (DE)**

(74) Representative: **Fitzner, Uwe**
**Dres. Fitzner & Münch**
**Patent- und Rechtsanwälte**
**Hauser Ring 10**
**40878 Ratingen (DE)**

(54) **Method for manufacturing integrated circuit devices, optical devices, micromachines and mechanical precision devices having patterned material layers with line-space dimensions of 50 nm and less**

(57)   A method for manufacturing integrated circuit devices, optical devices, micromachines and mechanical precision devices, the said method comprising the steps of

(1) providing a substrate having patterned material layers having line-space dimensions of 50 nm and less and aspect ratios of >2;

(2) providing the surface of the patterned material layers with a positive or a negative electrical charge by contacting the substrate at least once with an aqueous, fluorine-free solution S containing at least one fluorine-free cationic surfactant A having at least one cationic or potentially cationic group, at least one fluorine-free anionic surfactant A having at least one anionic or potentially anionic group, or at least one fluorine-free amphoteric surfactant A; and

(3) removing the aqueous, fluorine-free solution S from the contact with the substrate.

## Figure 1

**Description**

The present invention is directed to a novel method for manufacturing integrated circuits devices, optical devices, micromachines and mechanical precision devices having patterned material layers having line-space dimensions of 50 nm and less and aspect ratios >2.

Cited Documents

The documents cited in the present application are incorporated by reference in their entirety.

Background of the Invention

In the process of manufacturing ICs with LSI, VLSI and ULSI, patterned material layers like patterned photoresist layers, patterned barrier material layers containing or consisting of titanium nitride, tantalum or tantalum nitride, patterned multi-stack material layers containing or consisting of stacks e.g. of alternating polysilicon and silicon dioxide layers, and patterned dielectric material layers containing or consisting of silicon dioxide or low-k or ultra-low-k dielectric materials are produced by photolithographic techniques. Nowadays, such patterned material layers comprise structures of dimensions even below 20 nm with high aspect ratios.

Photolithography is a method in which a pattern on a mask is projected onto a substrate such as a semiconductor wafer. Semiconductor photolithography typically includes the step of applying a layer of a photoresist on a top surface of the semiconductor substrate and exposing the photoresist to actinic radiation, in particular UV radiation of a wavelength of, for example, 193 nm, through the mask. In order to extend the 193 nm photolithography to the 20 nm and the 15 nm node, immersion photolithography has been developed as a resolution enhancement technique. In this technique, the air gap between the final lens of the optical system and the photoresist surface is replaced by a liquid medium that has a refractive index greater than one, e.g., ultra pure water with a refractive index of 1.44 for the wavelength of 193 nm. However, in order to avoid leaching, water-uptake and pattern degradation, a barrier coating or a water resistant photoresist must be used. These measures however add to the complexity of the manufacturing process and are therefore disadvantageous.

A post-exposure bake (PEB) is often performed to allow the exposed photoresist polymers to cleave. The substrate including the cleaved polymer photoresist is then transferred to a developing chamber to remove the exposed photoresist, which is soluble in aqueous developer solutions. Typically, a developer solution such as tetramethylammonium hydroxide (TMAH) is applied to the resist surface in the form of a puddle to develop the exposed photoresist. A deionized water rinse is then applied to the substrate to remove the dissolved polymers of the photoresists. The substrate is then sent to a spin drying process. Thereafter, the substrate can be transferred to the next process step, which may include a hard bake process to remove any moisture from the photoresist surface.

This conventional process however involves a plurality of problems. As technologies advance and dimension requirements become stricter and stricter, photoresist patterns are required to include relatively thin and tall structures or features of photoresists, i.e., features having a high aspect ratio, on the substrate. These structures may suffer from bending and/or collapsing, in particular, during the spin dry process, due to excessive capillary forces of the deionized water remaining from the chemical rinse and spin dry processes and being disposed between adjacent photoresist features. The maximum stress $\sigma$ between small features caused by the capillary forces can be defined as follows:

$$\sigma = 6 \cdot \gamma \cdot \cos\theta / D \cdot (H \cdot W)^2,$$

wherein $\gamma$ = surface tension of the fluid, $\theta$ = contact angle of the fluid on the feature material surface, D = distance between the features, H = height of the features, and W = width of the features. Consequently, the surface tension of the chemical rinse solutions must be significantly lowered.

Another solution for immersion lithography may include using a photoresist with modified polymers to make it more hydrophobic. However, this solution may decrease the wettability of the developing solution.

Another problem of the conventional photolithographic process is line edge roughness (LER) due to resist and optical resolution limits. LER includes horizontal and vertical deviations from the feature's ideal form. Especially as critical dimensions shrink, the LER becomes more problematic and may cause yield loss in the manufacturing process of IC devices.

Due to the shrinkage of the dimensions, the removal of particles in order to achieve a defect reduction becomes also a critical factor. This does not only applying to photoresist patterns but also to other patterned material layers which are generated during the manufacture of optical devices, micromachines and mechanical precision devices.

An additional problem of the conventional photolithographic process is the presence of watermark defects. Watermarks may form on the photoresist as the deionized water from the deionized water rinse cannot be spun off from the hydrophobic surface of the photoresist. The photoresist may be hydrophobic particularly in areas of isolated, or nondense, patterning. The watermarks have a harmful effect on yield and IC device performance.

The American patent application US 2008/0280230 A1 discloses a chemical rinse solution containing an alcohol, in particular, isobutyl alcohol.

Moreover, the chemical rinse solution may contain fluorosurfactants such as 3M Novec™ fluid HFE-711 PA, -7000, -7100, -7200, and 7500, 3M Fluorinert™ FC-72, -84, -77, -3255, -3283, -40, -43, -70, -4432, 4430, and -4434, or 3M Novec™ 4200 and 4300.

For instance, 3M Novec™ 4200 is a perfluoroalkyl sulfonamide, 3M Novec™ 4300 is a perfluoroalkyl sulfonate, HFE-7000 is heptafluoro-3-methoxypropane, HFE-7100 is nonafluoro-4-methoxybutane, HFE-7200 is 1-ethoxy-nonafluorobutane, HFE-7500 is 3-ethoxy-dodecafluoro-2-(trifluoromethyl)-hexane, and HFE-711 PA is an azeotrope of 1-methoxy-nonafluorobutane and isopropanol. The 3M Fluorinert™ series surfactants are customarily used as inert perfluorinated heat transfer media.

The American patent application US 2008/0299487 A1 teaches the use of the above mentioned fluorosurfactants as additives to developer and chemical rinse solutions as well as to the immersion photoresist material. Moreover, 3M L-18691, an aqueous solution of perfluoroalkyl sulfonimide, can also be used. Additionally, the use of the following fluorosurfactants is suggested:

- $Rf-SO_3^-M^+$, wherein Rf is a C1-C12 perfluoroalkyl group and $M^+$ is a cation, a proton or an ammonium group;
- $Rf-SO_2N^--R^1M^+$, wherein Rf and $M^+$ have the abovementioned meaning and $R^1$ is a hydrogen atom, an alkyl group, a hydroxyalkyl group, an alkylamine oxide group, an alkylcarboxylate group or an aminoalkyl group, the alkyl, hydroxyalkyl, alkylamine oxide, alkylcarboxylate and aminoalkyl groups having preferably 1-6 carbon atoms and the hydroxyalkyl having preferably the formula $-(CH_2)_x-OH$, wherein x = 1-6; and
- $Rf-Q-R^1SO_3-M^+$, wherein Rf and $M^+$ have the abovementioned meaning and R1 is an alkylene of the formula $-C_nH_{2n}(CHOH)_oC_mH2_m-$, wherein n and m are independently of each other 1-6 and o is 0-1, and is optionally substituted by catenary oxygen or nitrogen group, Q is -O- or $-SO_2NR^2-$, wherein $R^2$ is a hydrogen atom, or an alkyl, aryl, hydroxyalkyl, aminoalkyl, or a sulfonatoalkyl group having 1-6 carbon atoms, optionally containing one or more catenary oxygen or nitrogen heteroatoms; the hydroxyalkyl group may be of the formula $-C_pH_{2p}-OH$, wherein p is 1-6; the aminoalkyl group may be of the formula $-C_pH_{2p}-NR^3R^4$, wherein p is 1-6 and $R^3$ and $R^4$ are independently of each other hydrogen atoms or alkyl groups of 1-6 carbon atoms.

The American patent applications US 2008/0280230 A and US 2008/0299487 A1 remain silent as to whether the chemical rinse solutions containing such an ionic fluorosurfactant can meet the ever increasing demands of the IC manufacturing industry, in particular with regard to pattern collapse in the 32 nm and sub-32 nm technology nodes.

The international patent applications WO 2008/003443 A1, WO 2008/003445 A1, WO 2008/003446 A2 and WO 2009/149807 A1 and the American patent application US 2009/0264525 A1 disclose inter alia cationic and anionic fluorosurfactants. These known fluorosurfactants find numerous applications, for example, in textile, paper, glass, building, coating, cleaner, cosmetic, herbicide, pesticide, fungicide, adhesive, metal, or mineral oil technologies as well as in special coatings for semiconductor photolithography (photoresist, top antireflective coatings, bottom antireflective coatings) [cf., for example WO 2008/003446 A2, page 14, line 29 to page 20, line 20]. The use of the fluorosurfactants for manufacturing ICs for nodes of 50 nm and lower, in particular for 32 nm nodes and lower, is not disclosed. Moreover, many of these prior art fluorosurfactants are not easily biodegradable and are therefore prone to bioaccumulation.

Objects of the Invention

It is the object of the present invention to provide a method for manufacturing integrated circuits for nodes of 50 nm and lower, in particular for nodes of 32 nm and lower and, especially, for nodes of 20 nm and lower, which method no longer exhibits the disadvantages of prior art manufacturing methods.

In particular, the novel method should allow for the immersion photolithography of photoresist layers, the developing of the photoresist layers exposed to actinic radiation through a mask and/or the chemical rinse of patterned material layers comprising patterns with a high aspect ratio and line-space dimensions of 50 nm and less, in particular, of 32 nm and less, especially, of 20 nm and less, without causing pattern collapse, line edge roughness (LER) and watermark defects.

Quite to the contrary, the novel method should allow for a significant reduction of LER by smoothing the roughness of the surfaces of the developed photoresist patterns caused by interference effects, for the efficient prevention and/or the removal of watermark defects not only on photoresist patterns but also on other patterned material layers, and the efficient removal of particles in order to achieve a significant defect reduction not only on photoresist patterns but also on other patterned material layers.

Moreover, the novel method should not incur the disadvantages associated with the use of fluorosurfactants, in particular, insufficient biodegradability and bioaccumulation.

Summary of the Invention

Accordingly, the novel method for manufacturing integrated circuit devices, optical devices, micromachines and mechanical precision devices has been found, the said method comprising the steps of

(1) providing a substrate having patterned material layers having line-space dimensions of 50 nm and less and aspect ratios of >2;

(2) providing the surface of the patterned material layers with a positive or a negative electrical charge by contacting the substrate at least once with an aqueous, fluorine-free solution S containing at least one fluorine-free cationic surfactant A having at least one cationic or potentially cationic group, at least one fluorine-free anionic surfactant A having at least one anionic or potentially anionic group, or at least one fluorine-free amphoteric surfactant A; and

(3) removing the aqueous, fluorine free solution S from the contact with the substrate.

Hereinafter the novel method for manufacturing integrated circuit devices, optical devices, micromachines and mechanical precision devices is referred to as the "method of the invention".

Advantages of the Invention

In view of the prior art, it was surprising and could not be expected by the skilled artisan that the objects of the invention could be solved by the method of mean invention.

It was particularly surprising that the method of the invention allowed for the immersion photolithography of photoresist layers, the developing of photoresist layers exposed to actinic radiation through a mask and/or the chemical rinse of patterned material layers, in particular, patterned developed photoresist layers, comprising patterns having line-space dimensions of 50 nm and less, particularly, of 32 nm and less and, most particularly, 20 nm and less, and aspect ratios >2 in the case of photoresist structures, and, in particular, >10 in the case of non-photoresist structures, without causing pattern collapse, line edge roughness (LER) and watermark defects.

In the art, structures having aspect ratios >10 are frequently referred to as "high aspect ratio stacks".

Quite to the contrary, the method of the invention allowed for a significant reduction of LER by smoothing the roughness of the surfaces of the developed photoresist patterns caused by interference effects, for the efficient prevention and/or the removal of watermark defects not only on photoresist patterns but also on other patterned material layers, and the efficient removal of particles whereby a significant defect reduction not only on photoresist patterns but also on other patterned material layers could be achieved.

Moreover, the method of the invention did not incur the disadvantages associated with the use of fluorosurfactants, in particular, insufficient biodegradability and bioaccumulation.

Detailed Description of the Invention

In its broadest aspect, the present invention is directed to a method of manufacturing integrated circuit (IC) devices, optical devices, micromachines and mechanical precision devices, in particular IC devices.

Any customary and known substrates used for manufacturing IC devices, optical devices, micromachines and mechanical precision devices can be used in the process of the invention. Preferably, the substrate is a semiconductor substrate, more preferably a silicon wafer including a silicon-gallium wafer, which wafers are customarily used for manufacturing IC devices, in particular IC devices comprising ICs having LSI, VLSI and ULSI.

In the first step of the method of the invention, a substrate is provided having patterned material layers having line-space dimensions of 50 nm and less, in particular, 32 nm and less and, especially, 20 nm and less, i.e. patterned material layers for the sub-20 nm technology nodes. The patterned material layers have ratios >2, preferably >10, even more preferably >50. In particular, when the patterned material layers comprise or consist of photoresist structures the ratios are >2 and when they comprise or consist of non-photoresist structures the ratios are >10. Most preferably, the aspect ratio is in the range of up to 75, as for example, for 15 nm flash devices.

The patterned material layers can be patterned developed photoresist layers, patterned barrier material layers containing or consisting of ruthenium, titanium nitride, tantalum or tantalum nitride, patterned multi-stack material layers containing or consisting of layers of at least two different materials selected from the group consisting of silicon, polysilicon, silicon dioxide, low-k and ultra-low-k materials, high-k materials, semiconductors other than silicon and polysilicon and metals; and patterned dielectric material layers containing or consisting of silicon dioxide or low-k or ultra-low-k dielectric materials.

In the second step of the method of the invention, the surface of the patterned material layers is provided with a positive or a negative electrical charge by contacting the semiconductor substrate at least once with an aqueous, fluorine-free solution S containing at least one fluorine-free ionic surfactant A having at least one cationic or potentially cationic group or having at least one anionic or potentially anionic group.

"Aqueous" means that the aqueous, fluorine-free solution S contains the water, preferably deionized water and, most preferably ultrapure water as the main solvent. The aqueous, fluorine-free solution S may contain water-miscible polar organic solvents, albeit only in such minor amounts that do jeopardize the aqueous nature of the solution S.

"Fluorine-free" means that the concentration of fluoride ions or covalently bonded fluorine in the solution S is below the detection limit of customary and known methods for quantitatively or qualitatively detecting fluorine.

The aqueous, fluorine-free solution S can be applied in accordance with any known methods customarily used for contacting solid surfaces with liquids, as for example, dipping the substrates into the solution S or spraying, dropping or puddling the solution S onto the substrate surface.

The aqueous, fluorine-free solution S contains at least one, preferably one, fluorine-free cationic surfactant A having at least one cationic or potentially cationic group, at least one, preferably one, fluorine-free anionic surfactant A having at least one anionic or potentially anionic group, or at least one, preferably one, fluorine-free amphoteric surfactant.

Preferably, the at least one cationic or potentially cationic group contained in the fluorine-free cationic surfactant A is selected from the group consisting of primary, secondary and tertiary amino groups, primary, secondary, tertiary and quaternary ammonium groups, uronium-, thiouronium- und guanidinium groups, quaternary phosphonium groups and tertiary sulfonium groups.

Preferably, the secondary and tertiary amino groups, the secondary, tertiary and quaternary ammonium groups, the tertiary sulfonium groups and the quaternary phosphonium can comprise any organic residues as long as these residues do not jeopardize the hydrophilic nature of the cationic or potentially cationic group. More preferably, the organic residues are selected from the group consisting of substituted and unsubstituted, preferably unsubstituted, alkyl groups having 1 to 10 carbon atoms, cycloalkyl groups having 5 to 12 carbon atoms, aryl groups having 6 to 16 carbon atoms and alkylcycloalkyl groups, alkylaryl groups, cycloalkylaryl groups and alkylcycloalkylaryl groups containing or consisting of the aforementioned alkyl, cycloalkyl and aryl groups. Moreover, the secondary and tertiary amino groups and the secondary, tertiary and quaternary ammonium groups can be integral constituents of cationic substituted and unsubstituted, preferably unsubstituted, heterocyclic groups, preferably selected from the group consisting of pyrrolium-, imidazolium-, imidazolinium, 1H-pyrazolium-, 3H-pyrazolium-, 4H-pyrazolium-, 1-pyrazolinium-, 2-pyrazolinium-, 3-pyrazolinium-, 2,3-dihydro-imidazolinium-, 4,5-dihydro-imidazolinium-, 2,5-dihydro-imidazolinium-, pyrrolidinium-, 1,2,4-triazolium- (quaternary nitrogen atom in 1-position), 1,2,4-triazolium-(quaternary nitrogen atom in 4-position), 1,2,3-triazolium- (quaternary nitrogen in 1-position), 1,2,3-triazolium- (quaternary nitrogen in 4-position), oxazolium-, oxazolinium isooxazolium-, thiazolium-, isothiazolium-, pyridinium-, pyridazinium-, pyrimidinium-, piperidinium-, morpholinium-, pyrazinium-, indolium-, chinolinium-, isochinolinium-, chinoxalinium- und indolinium-cations.

The aforementioned substituted organic moieties and cationic heterocyclic groups contain inert substituents, i.e., substituents which do not cause undesired effects such as decomposition or condensation reactions or the formation of precipitates. Examples for suitable substituents are nitrile groups, nitro groups and chlorine atoms.

Preferably, the counterions of the cationic groups are selected from the group consisting of anions of volatile inorganic and organic acids, in particular, HCl, formic acid, acetic acid and salicylic acid.

Preferably, the potentially anionic and anionic groups of the fluorine-free anionic surfactants A are selected from the group consisting of carboxylic acid, sulfonic acid, phosphonic acid, sulfuric acid monoester, phosphoric acid monoester and phosphoric acid diester groups and carboxylate, sulfonate, phosphonates, monoester sulfate, monoester phosphate and diester phosphate groups.

Preferably, the counterions of the anionic groups are selected from the group consisting of ammonium, lithium, sodium, potassium and magnesium cations. Most preferably, ammonium is used as the counterion.

In addition to the above described potentially ionic or ionic hydrophilic groups, the surfactants A can contain nonionic hydrophilic groups customarily used in nonionic surfactants. Preferably, the nonionic hydrophilic groups selected from the group consisting of hydroxy groups, -O-, -S-, -C(O)-, -C(S)-, -C(O)-O-, -O-C(O)-O-, -O-C(S)-O-, -O-Si(-R)$_2$-,- N=N-, -NR-C(O)-, -NR-NR-C(O)-, -NR-NR-C(S)-, -O-C(O)-NR-, -O-C(S)-NR-, -NR-C(O)-NR-, -NR-C(S)-NR-, -S(O)-, -S(O)$_2$-, -O-S(O)$_2$-, -NR-S(O)$_2$-, -P(O)$_2$-O-, sorbitol, glucose, fructose, oligoglucose, saccharose, polyoxyethylene groups, polyoxypropylene groups and polyoxyethylene-polyoxypropylene groups.

The anionic and cationic surfactants A contain at least one hydrophobic group. Preferably, any suitable hydrophobic group customarily used in ionic surfactants can be used. Most preferably, the hydrophobic groups are selected from the group consisting of substituted and unsubstituted, preferably, unsubstituted, branched and unbranched, saturated and unsaturated alkyl groups having 5 to 30 carbon atoms, cycloalkyl groups having 5 to 20 carbon atoms, aryl groups having 6 to 20 carbon atoms, alkylcycloalkyl groups, alkylaryl groups, cycloalkylaryl groups and alkylcycloalkylaryl containing or consisting of the aforementioned alkyl, cycloalkyl and aryl groups, and polysiloxane groups.

The aforementioned substituted hydrophobic groups contain inert substituents, i.e., substituents which do not jeopardize the hydrophobic nature of the group and do not cause undesired effects such as decomposition or condensation reactions or the formation of precipitates. Examples for suitable substituents are nitrile groups, nitro groups, fluorine atoms, and pentafluorosulfanyl groups.

Preferably, the fluorine-free amphoteric surfactant A is selected from the group consisting of alkylamine oxides, in particular alkyldimethylamine oxides; acyl-/dialkylethylendiamines, in particular sodium acylamphoacetate, disodium acylamphodipropionate, disodium alkylamphodiacetate, sodium acylamphohydroxypropylsulfonate, disodium acylamphodiacetate, sodium acyl-amphopropionate, and N-coconut fatty acid amidoethyl-N-hydroxyethylglycinate sodium salts; N-alkylamino acids, in particular aminopropyl alkylglutamide, alkylaminopropionic acid, sodium imidodipropionate and lauroamphocarboxyglycinate.

The fluorine-free surfactants A are customary and known commercially available materials and are described, for example, in Römpp Online 2011, "Cationic Surfactants", "Anionic Surfactants" and "Amphoteric Surfactants".

The concentration of the fluorine-free cationic, anionic or amphoteric surfactants A in the aqueous, fluorine-free solution S primarily depends on the critical micelle concentration value (CMC value). Therefore, the concentration can vary broadly and, therefore, can be adapted most advantageously to the particular requirements of a given method of the invention. Preferably, the concentration is in the range of 0.001 to 1% by weight, preferably 0.005 to 0.8% by weight and, most preferably, 0.01 to 0.6% by weight, the weight percentages being based on the complete weight of the solution S.

The aqueous, fluorine-free solution S may contain water-miscible polar organic solvents. Examples of and cleaning suitable solvents are described in the American patent application US 2008/0280230 A, page 2, paragraph [0016]. Most preferably, the aqueous, fluorine-free solution S does not contain any organic solvents.

In accordance with the method of the invention, the aqueous, fluorine-free solution S can be used for different purposes and objects. Thus, it can be used as an immersion liquid S for immersing photoresists during irradiation with actinic light through a mask, as a developer solution S for photoresist layers exposed to actinic radiation through a mask and as a chemical rinse solution S for rinsing the patterned material layers.

In the third step of the method of the invention, the aqueous solution S is removed from the contact with the substrate. Any known methods customarily used for removing liquids from solid surfaces can be employed. Preferably, the solution S is removed by spin drying or drying processes making use of the Marangoni effect.

Preferably, in the first step of the method of the invention, the substrate is provided by a photolithographic process comprising the steps of

(i) providing the substrate with an immersion photoresist layer;

(ii) exposing the photoresist layer to actinic radiation through a mask and an immersion liquid;

(iii) developing the exposed photoresist layer with a developer solution to obtain a pattern having line-space dimensions of 50 nm and less, in particular, of 32 nm and less and, most especially, of 20 nm and less and an aspect ratio >2, preferably >10, even more preferably >50 and, most preferably, up to 75 nm;

(iv) applying a chemical rinse solution to the developed patterned photoresist layer;
and

(v) drying the semiconductor substrate after the application of the chemical rinse, solution preferably by spin drying or drying processes making use of the Marangoni effect.

Any customary and known immersion photoresist can be used. The immersion photoresist may already contain at least one fluorine-free cationic, anionic or amphoteric surfactant A. Additionally, the immersion photoresist can contain nonionic surfactants. Suitable nonionic surfactants are described, for example, in the American patent application US 2008/0299487 A1, page 6, paragraph [0078]. Most preferably, the immersion photoresist is a positive resist.

Preferably, UV radiation of the wavelength of 193 nm is used as the actinic radiation.

Preferably, ultra-pure water is used as the immersion liquid. More preferably, the immersion liquid contains at least one fluorine-free cationic, anionic or amphoteric surfactant A.

Any customary and known developer solution can be used for developing the exposed photoresist layer. Preferably, aqueous developer solutions containing tetramethylammonium hydroxide (TMAH) are used. More preferably, the aqueous developer solutions contain at least one fluorine-free ionic surfactant A.

Preferably, the chemical rinse solutions are aqueous solutions. More preferably, the aqueous developer solutions contain at least one fluorine-free cationic, anionic or amphoteric surfactant A.

Preferably, the chemical rinse solutions are applied to the exposed and developed photoresist layers as puddles.

It is essential for photolithographic process according to the method of the invention, that at least one of the following: the immersion solution S, the developer solution S or the chemical rinse solution S contains at least one fluorine-free ionic surfactant A. Most preferably, the at least one fluorine-free cationic, anionic or amphoteric surfactant A is contained in the chemical rinse solution S.

Customary and known equipment customarily used in the semiconductor industry can be used for carrying out the photolithographic process in accordance with the method of the invention.

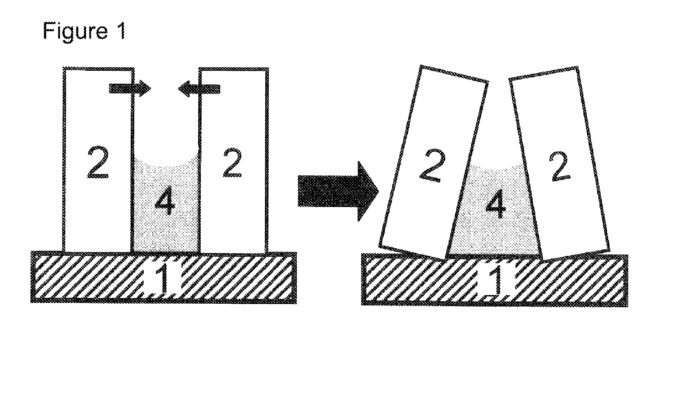

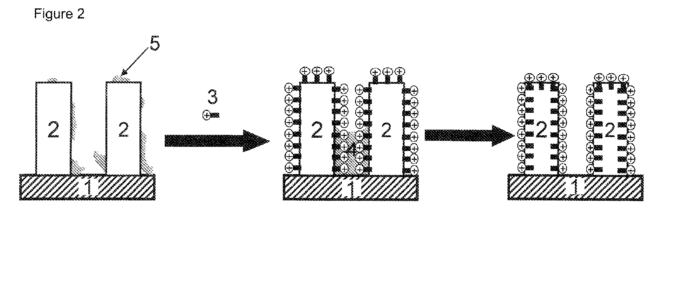

Without wishing to be bound by any theory, it is believed that the positive or negative electrical charge of the surface of the patterned layered materials causes a mutual electrostatic repulsion of neighboring surfaces which prevents pattern collapse, as illustrated by the Figures 1 and 2.

As the Figures 1 and 2 are of exemplary nature, the depicted spatial and dimensional relationships is not to be construed as an exact replica of the practical conditions.

In the Figures 1 and 2, the reference numbers have the following meaning.

1　　Substrate,
2　　photoresist or high aspect ratio stack,
3　　fluorine-free cationic, anionic or amphoteric surfactant A,
4　　cleaning solution containing no fluorine-free cationic, anionic or amphoteric surfactant A, and
5　　particles and residues.

Figure 1 illustrates how the photoresist structures or a high aspect ratio stacks 2 are drawn towards each other by the capillary forces of the evaporating cleaning solution 4, which capillary forces lead to pattern collapse.

Figure 2 illustrates the beneficial effect which is achieved when the fluorine-free cationic, anionic or amphoteric surfactant A is added to the cleaning solution 4, resulting in the aqueous fluorine-free solution S. The solution S effectively removes the particles and residues 5. Moreover, upon the evaporation of the solution S, some of the fluorine-free cationic, anionic or amphoteric surfactant A 3 is left on the surface of the structures, thereby creating a repulsive electrostatic force which prevents the pattern collapse.

Example

The Manufacture of Patterned Photoresist Layers Having Features with Line-Space Dimensions of 20 Nm with an Aspect Ratio of 50 Using a Fluorine-Free Ionic Surfactant Silicon wafers were provided with 1000 nm thick layers of an immersion photoresist. The photoresist layers were exposed to UV radiation of a wavelength of 193 through a mask using ultrapure water as the immersion liquid. The mask contained features having dimensions of 20 nm. Thereafter, the exposed photoresist layers were baked and developed with an aqueous developer solution containing TMAH. The baked and developed photoresist layers were subjected to a chemical rinse treatment using a chemical rinse solution containing 0.02% by weight of a fluorine-free cationic surfactant. The chemical rinse solution was applied as a puddle. Thereafter, the silicon wafers were spun dry. The dried silicon wafers did not show any watermarks. It could be corroborated by scanning electron microscopy (SEM) and atomic force microscopy (AFM) that the dried patterned photoresist layers having patterns with line-space dimensions of 20 nm and an aspect ratio of 50 did not show any pattern collapse.

**Claims**

1.　A method for manufacturing integrated circuit devices, optical devices, micromachines and mechanical precision devices comprising the steps of

　　(1) providing a substrate having patterned material layers having line-space dimensions of 50 nm and less and aspect ratios of >2;
　　(2) providing the surface of the patterned material layers with a positive or a negative electrical charge by contacting the semiconductor substrate at least once with an aqueous, fluorine-free solution S containing at least one fluorine-free cationic surfactant A having at least one cationic or potentially cationic group, at least one fluorine-free anionic surfactant A having at least one anionic or potentially anionic group, or at least one fluorine-free amphoteric surfactant A; and
　　(3) removing the aqueous, fluorine-free solution S from the contact with the substrate.

2.　The method according to claim 1, **characterized in that** the substrate is a semiconductor substrate.

3.　The method according to claim 1 or 2, **characterized in that** the patterned material layers are having a line-space dimensions of 32 nm and less and aspect ratios of >10 for non-photoresist structures and aspect ratios of >2 for photoresist structures.

4.　The method according to anyone of the claims 1 to 3, **characterized in that** the aqueous solution S is used as an immersion liquid S for immersing photoresists during irradiation with actinic light through a mask, a developer solution S for photoresists layers exposed to actinic radiation through a mask and an immersion liquid and/or as a chemical rinse solution S for rinsing the patterned material layers.

5.　The method according to anyone of the claims 1 to 4, **characterized in that** the patterned material layers are selected from the group consisting of patterned developed photoresist layers, patterned barrier material layers, patterned multi-stack material layers and pattern dielectric material layers.

6.　The method according to anyone of the claims 1 to 5, **characterized in that** the potentially cationic and cationic groups are selected from the group consisting of primary, secondary and tertiary amino groups, primary, secondary, tertiary and quaternary ammonium groups, uronium-, thiouronium- und guanidinium groups, quaternary phosphonium groups and tertiary sulfonium groups; and that the potentially anionic and anionic groups are selected from the group consisting of carboxylic acid, sulfonic acid, phosphonic acid, sulfuric acid monoester, phosphoric acid monoester and phosphoric acid diester groups and carboxylate, sulfonate, phosphonates, monoester sulfate, monoester phosphate and diester phosphate groups.

**7.** The method according to anyone of the claims 1 to 6, **characterized in that** the solution S contains, based on a complete weight of the solution S, 0.001 to 1% by weight of the ionic surfactant A.

**8.** The method according to anyone of the claims 1 to 7, **characterized in that** the solution S is removed from the contact with the substrate by spin drying or drying processes making use of the Marangoni effect.

**9.** The method according to anyone of the claims 1 to 8, **characterized in that** the substrate having patterned material layers having line-space dimensions of 50 nm and less and aspect ratios of >2 is provided by a photolithographic process.

**10.** The method according to claim 9, **characterized in that** the photolithographic process comprises the steps of

(i) providing the substrate with an immersion photoresist layer;
(ii) exposing the photoresist layer to actinic radiation through a mask and an immersion liquid;
(iii) developing the exposed photoresist layer with a developer solution to obtain a pattern having line-space dimensions of 32 nm and less and an aspect ratio >2;
(iv) applying a chemical rinse solution to the developed patterned photoresist layer; and
(v) spin drying the semiconductor substrate after the application of the
chemical rinse solution;

wherein at least one of the following: the immersion liquid, the developer solution and the chemical rinse solution, is an aqueous, fluorine-free solution S.

**11.** The method according to anyone of the claims 1 to 10, **characterized in that** it is used for preventing pattern collapse, for reducing line edge roughness, for preventing and removing watermark defects and for reducing defects by removing particles.

**12.** The method according to anyone of the claims 1 to 11, **characterized in that** the integrated circuit devices comprise integrated circuits having a large-scale integration (LSI), very-large-scale integration (VLSI) or the ultra-large-scale integration (ULSI).

Figure 1

Figure 2

Europäisches
Patentamt
European
Patent Office
Office européen
des brevets

# EUROPEAN SEARCH REPORT

Application Number

EP 11 15 8833

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 553 454 A2 (MATSUSHITA ELECTRIC IND CO LTD [JP]) 13 July 2005 (2005-07-13) * claim 16 * * embodiments 4 and 6 * ----- | 1-12 | INV. G03F7/40 G03F7/20 |
| X | KWANGJOO LEE: "Amplification of the index of refraction of aqueous immersion fluids by ionic surfactants", PROCEEDINGS OF SPIE, vol. 5753, 1 January 2005 (2005-01-01), pages 537-553, XP055002751, ISSN: 0277-786X, DOI: 10.1117/12.606105 * the whole document * * page 539 - paragraph 2 * ----- | 1-12 | |
| X | JP 2007 258638 A (SONY CORP) 4 October 2007 (2007-10-04) * claim 5 * * page 5, paragraph 28 * ----- | 1-12 | |
| | | | **TECHNICAL FIELDS SEARCHED (IPC)** G03F |

~~The present search report has been drawn up for all claims~~

| Place of search | Date of completion of the search | Examiner |
|---|---|---|
| The Hague | 22 July 2011 | Le Masson, Nicolas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

Application Number

EP 11 15 8833

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

see annex

☐ The present supplementary European search report has been drawn up for those parts of the European patent application which relate to the invention first mentioned in the claims (Rule 164 (1) EPC).

# EP 2 500 777 A1

Europäisches
Patentamt
European
Patent Office
Office européen
des brevets

**LACK OF UNITY OF INVENTION**
**SHEET B**

**Application Number**

EP 11 15 8833

The Search Division considers that the present European patent application does not comply with the requirements of unity of invention and relates to several inventions or groups of inventions, namely:

1. claims: 1-12(partially)

    a method for manufacturing integrated circuit devices, optical devices, micromachines and mechanical precision devices comprising the steps of
    (1) providing a substrate having patterned material layers having line-space dimensions of 50 nm and less and aspect ratios of >2;
    (2) providing the surface of the patterned material layers with a positive or a negative electrical charge by contacting the semiconductor substrate at least once with an aqueous, fluorine-free solution S containing at least one fluorine-free cationic surfactant A having at least one cationic or potentially cationic group, at least one fluorine-free anionic surfactant A having at least one anionic or potentially anionic group, or at least one fluorine-free amphoteric surfactant A; and
    (3) removing the aqueous, fluorine-free solution S from the contact with the substrate,
    wherein the solution S is used as an immersion liquid for immersing photoresists during irradiation with actinic light through a mask.
    ---

2. claims: 1-12(partially)

    a method for manufacturing integrated circuit devices, optical devices, micromachines and mechanical precision devices comprising the steps of
    (1) providing a substrate having patterned material layers having line-space dimensions of 50 nm and less and aspect ratios of >2;
    (2) providing the surface of the patterned material layers with a positive or a negative electrical charge by contacting the semiconductor substrate at least once with an aqueous, fluorine-free solution S containing at least one fluorine-free cationic surfactant A having at least one cationic or potentially cationic group, at least one fluorine-free anionic surfactant A having at least one anionic or potentially anionic group, or at least one fluorine-free amphoteric surfactant A; and
    (3) removing the aqueous, fluorine-free solution S from the contact with the substrate,
    wherein the solution S is used as a developer solution for photoresists layers exposed to actinic radiation through a mask and an immersion liquid.
    ---

3. claims: 1-12(partially)

    a method for manufacturing integrated circuit devices,

Europäisches
Patentamt

European
Patent Office

Office européen
des brevets

**LACK OF UNITY OF INVENTION
SHEET B**

Application Number

EP 11 15 8833

The Search Division considers that the present European patent application does not comply with the
requirements of unity of invention and relates to several inventions or groups of inventions, namely:

optical devices, micromachines and mechanical precision
devices comprising the steps of
(1) providing a substrate having patterned material layers
having line-space dimensions of 50 nm and less and aspect
ratios of >2;
(2) providing the surface of the patterned material layers
with a positive or a negative electrical charge by
contacting the semiconductor substrate at least once with an
aqueous, fluorine-free solution S containing  at least one
fluorine-free cationic surfactant A having at least one
cationic or potentially cationic group, at least one
fluorine-free anionic surfactant A having at least one
anionic or potentially anionic group, or at least one
fluorine-free amphoteric surfactant A; and
(3) removing the aqueous, fluorine-free solution S from the
contact with the substrate,
wherein the solution S is used as a chemical rinse solution
for rinsing the patterned material layers.
---

## ANNEX TO THE EUROPEAN SEARCH REPORT
## ON EUROPEAN PATENT APPLICATION NO.

EP 11 15 8833

This annex lists the patent family members relating to the patent documents cited in the above-mentioned European search report.
The members are as contained in the European Patent Office EDP file on
The European Patent Office is in no way liable for these particulars which are merely given for the purpose of information.

22-07-2011

| Patent document cited in search report | | Publication date | Patent family member(s) | | Publication date |
|---|---|---|---|---|---|
| EP 1553454 | A2 | 13-07-2005 | CN<br>EP<br>US | 1638037 A<br>1553454 A2<br>2005158672 A1 | 13-07-2005<br>13-07-2005<br>21-07-2005 |
| JP 2007258638 | A | 04-10-2007 | NONE | | |

EPO FORM P0459

For more details about this annex : see Official Journal of the European Patent Office, No. 12/82

## EP 2 500 777 A1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080280230 A1
- US 20080299487 A1
- US 20080280230 A
- WO 2008003443 A1
- WO 2008003445 A1
- WO 2008003446 A2
- WO 2009149807 A1
- US 20090264525 A1